# EUROPEAN PATENT APPLICATION

(11) **EP 2 128 908 A2**
(43) Date of publication of application: **02.12.2009**
(21) Application number: 09425203.8
(22) Date of filing: 25.05.2009
(51) Int. Cl.: H01L 35/32

(54) **Thermoelectric generator**

(30) Priority: 30.05.2008 IT RM20080285
(71) Applicant: Facchiano, Giovanni, 00124 Roma (IT); Barbieri, Antonio, 00125 Roma (IT); Tucceri, Alberto, 00142 Roma (IT)
(72) Inventor: Facchiano, Giovanni, 00124 Roma (IT); Facchiano, Allesandro, 00124 Roma (IT)
(74) Representative: Iannone, Carlo Luigi

(57) **Abstract**

The invention relates to a thermoelectric generator suitable to transform thermal energy into electric energy exploiting low, medium and high temperatures, characterized in there are provided, in series, an electropositive conductor and an electronegative conductor, placed between two substantially parallel elements or panels, having coupling points of said conductors respectively on a hot side and on a cold side, said arrangement being provided within a structure wherein a thermal exchange is generated yielding heat, and with generation of electric energy.

## Description

The present invention relates to a high efficiency thermoelectric generator for producing electric energy exploiting the thermal difference.

More specifically, the invention concerns an innovative system permitting increasing of about four times production of electric energy, doubling the use surface, thus permitting obtaining higher energies with respect to known solutions, by exploiting in an absolutely new way the Seebeck effect.

As it well known, by Seebeck effect (which is the operating principle of thermocouples) it is possible transforming electric energy obtained from heat by through a metal. At present, systems employed to this end are already known on the market.

However, the use of said technologies is limited by a scarce production of electric energy with respect to the thermal energy employed.

It is further known the use of thermocouples for small productions of electric energy, which is employed for safety of thermal systems.

It is evident that these features are not satisfactorily in terms of energy in order to permit a large development of exploitation of this energy.

In view of the above, it s well evident the advantage of developing technical solutions permitting improving electric efficiency based on thermal energy available in this kind of systems.

These and other results are obtained by the solution according to the invention that, applying in a different way conductive metals, permits obtaining a higher electric energy. Furthermore, the system according to the invention permits the use also with low temperatures, thus widening the applicative field to other type of energy recovery.

It is therefore specific object of the present invention a thermoelectric generator suitable to transform thermal energy into electric energy exploiting low, medium and high temperatures, characterized in there are provided, in series, an electropositive conductor and an electronegative conductor, placed between two substantially parallel elements or panels, having coupling points of said conductors respectively on a hot side and on a cold side, said arrangement being provided within a structure wherein a thermal exchange is generated yielding heat, and with generation of electric energy.

Preferably, according to the invention, said conductors are connected in series each other, so as to create a single and continuous body, said conductors being realized employing at least two different metallic wires welded at their ends and insulated each other, so as to realizes a continuous series of welded joints on the hot side of the panel and a continuous series on the cold side of the panel.

Still according to the invention, two metallic conductors are provided, respectively an electropositive and an electronegative conductors, welded each other at their ends so as to realize a thermocouple based on the Seebeck effect, all the metallic pairs being weld in series each other.

Preferably, according to the invention, said thermoelectric generator is comprised of modules and electrodes connected in series each other so as to transform thermal energy into electric energy.

According to the invention, said thermoelectric generator can be used as solar panel for production of electric energy, or as additional panel to the photovoltaic panel to increase production of electric energy exploiting heat of the same photovoltaic panel, or to produce electric energy from discharge gases of exothermic systems, or to produce electric energy from discharge gases of endothermic systems, or to produce electric energy from return energy of geothermic systems, or for producing electric energy from flame heat of gases burnt within oil refineries and systems, or for producing electric energy between the different temperature of water and air applied to boats.

The present invention will be now described, for illustrative but not limitative purposes, according to its preferred embodiments, with particular reference to the figure of the enclosed drawings, wherein
figure 1 shows a scheme representing conductive metal in series for exploiting Seebeck effect;
figure 2 shows a first scheme of a thermoelectric generator according to the invention;

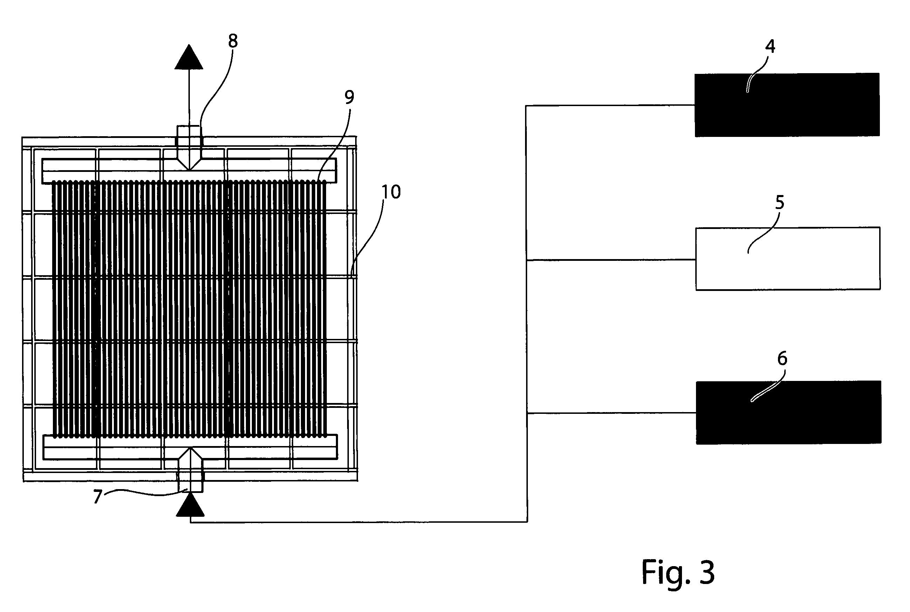

figure 3 shows a second scheme of a thermoelectric generator according to the invention;

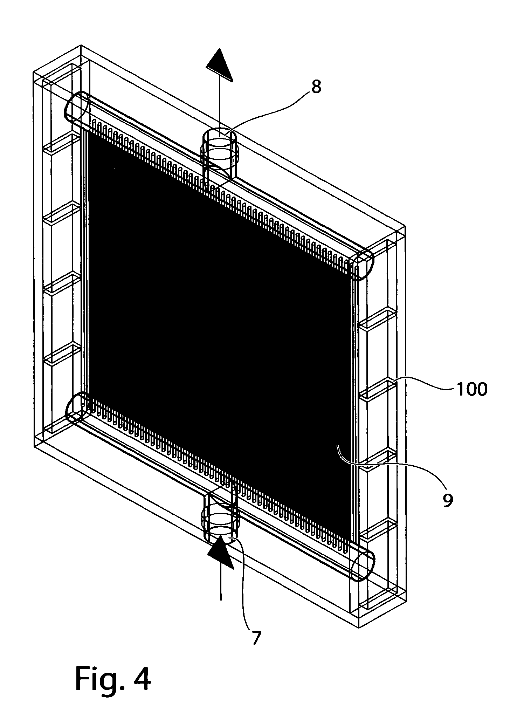

figure 4 is a perspective view of an element of generator of figure 3;
figure 5 is a second perspective view of an element of the generator of figure 3;
figure 6 shows a table permitting evaluating energy production obtained by the generator according to the invention with referenced to photovoltaic systems; and
figure 7 shows a graph indicating efficiency obtained applying the innovative system with a thermal exchange room to every kind of system having discharge gases.

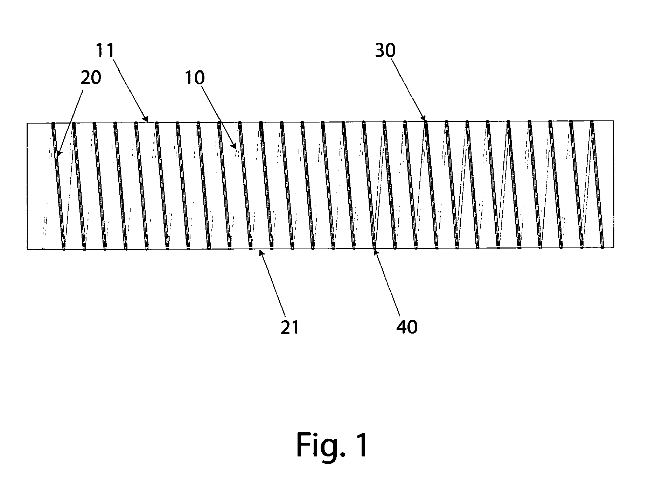

As it is observed in figure 1, two conductors, respectively an electropositive conductor 10 and an electronegative conductor 20, are provided in series, with two welding points, respectively on the hot side 30 and on the cold side 40, placed between two plates 11 and 21.

In order to exploit Seebeck effect it is necessary realizing a temperature Δ between hot side 11 and cold side 21.

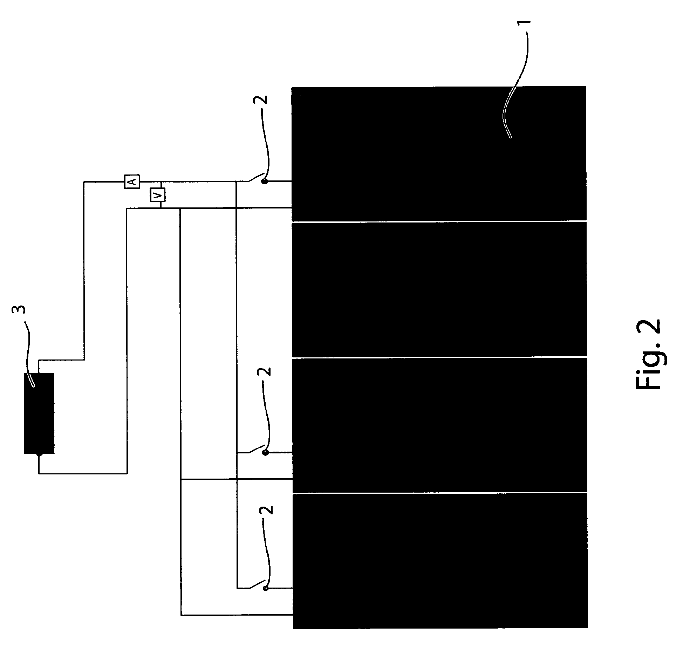

A possible application is shown in figure 2 of the enclosed drawings, wherein solar modules are indicated by reference number 1, for example having each one 50 elements, and switches are indicated by reference number 2, while resistance for dissipation of electric energy produced is indicated by reference number 3.

A voltmeter V and an amperometer A are further provided.

A heat source from a photovoltaic system, a discharge gas heat source of an endothermic system, a heat source from discharge gases of an exothermic system are shown in the following figures and respectively indicated by reference numbers 4, 5 and 6.

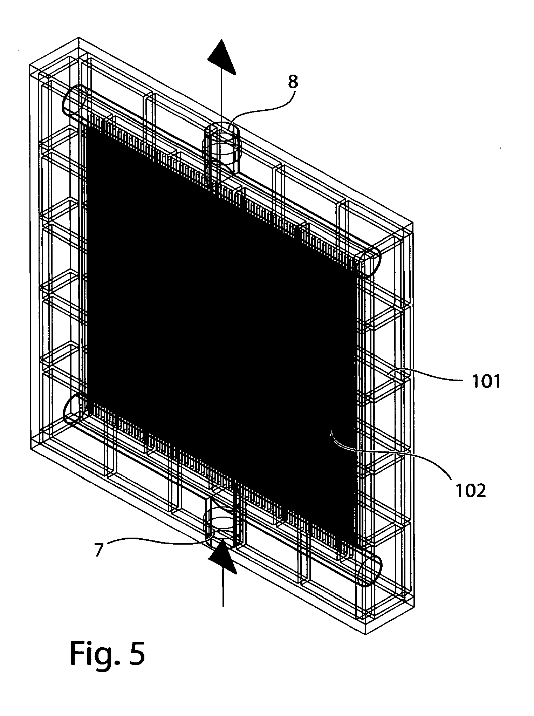

Furthermore, discharge gas 7 inlet, outlet of discharge gases 8, thermal exchanger 9, electric energy conversion plates 100 and electric modules support metallic structure are shown in the figures. Lateral electric generators 101 and central electric generator modules 102 are shown in figure 5.

Within the structure through which hot gas is made passing to obtain the heat cession, it is provided a series comprised of the electropositive conductor 10 and the electronegative conductor 20, in order to realize a hot side and a cold side, thus exploiting the Seebeck effect.

During the experimental phase it has been realized a model with two panels having each one 54 elements, and a circuit dividing the elements according to the distribution 27/54/10, a resistance absorbing electric energy produced and two instruments for measuring both voltage and amperage of energy produced.

It can be obtained a first arrangement with an open circuit having 27 elements, a second arrangement with open circuit having 54 elements, from which it can be noted that doubling the elements provided in series, electric energy produced with respect to the first arrangement is multiplied about 4 times, and a third arrangement with open circuit having 108 elements, wherein it can be observed that doubling the elements provided in series, electric energy produced with respect to the second arrangement is multiplied about 4 times.

It has been furthermore realized an experimental model for high temperatures comprised of two panels, having 108 elements each one, a thermal exchange chamber for production of electric energy, a thermostat for controlling temperature, a voltmeter and an amperometer for displaying energy produced and a resistance for dissipating electric energy produced.

Experimental model has been realized in order to demonstrate the usefulness of the solution according to the invention exploiting temperatures higher than 100°C.

It is obtained a first arrangement with an open circuit having 108 elements, wherein it can be observed that energy produced remarkably increases with respect to the increase of temperature, a second arrangement with open circuit having 216 elements, from which it can be noted that doubling the elements provided in series, electric energy produced with respect to the first arrangement is multiplied about 4 times.

It is known that photovoltaic modules, while transforming energy of photons of solar light into electric energy, it is developed thermal energy, said energy even reaching 50°.

The solution suggested according to the present invention, it permits transforming said energy into electric energy.

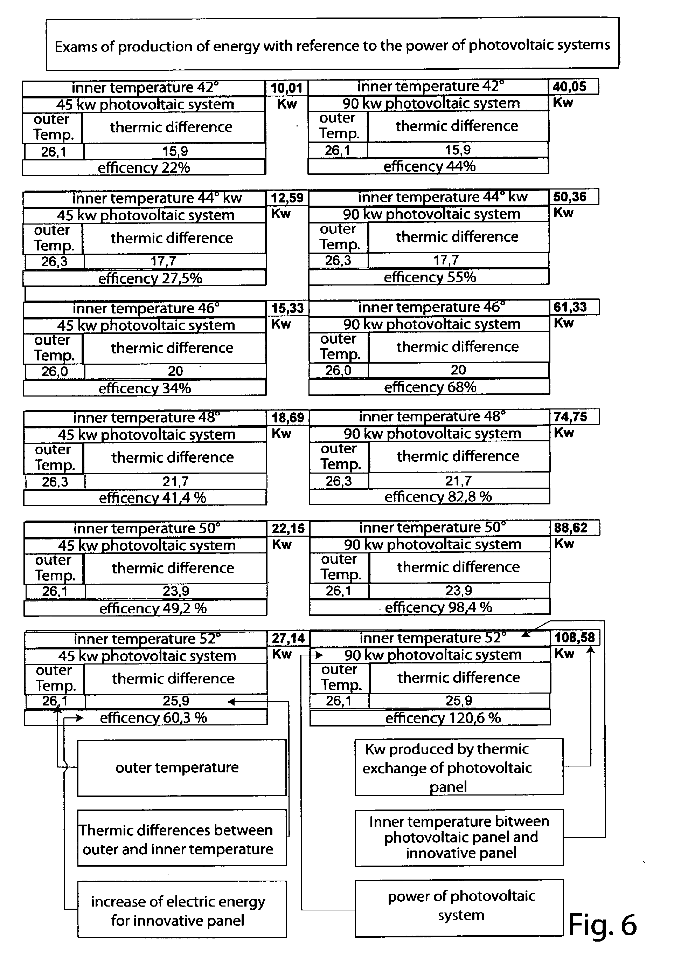

In table of figure 6, efficiency obtained applying the system according to the invention to a photovoltaic system are shown.

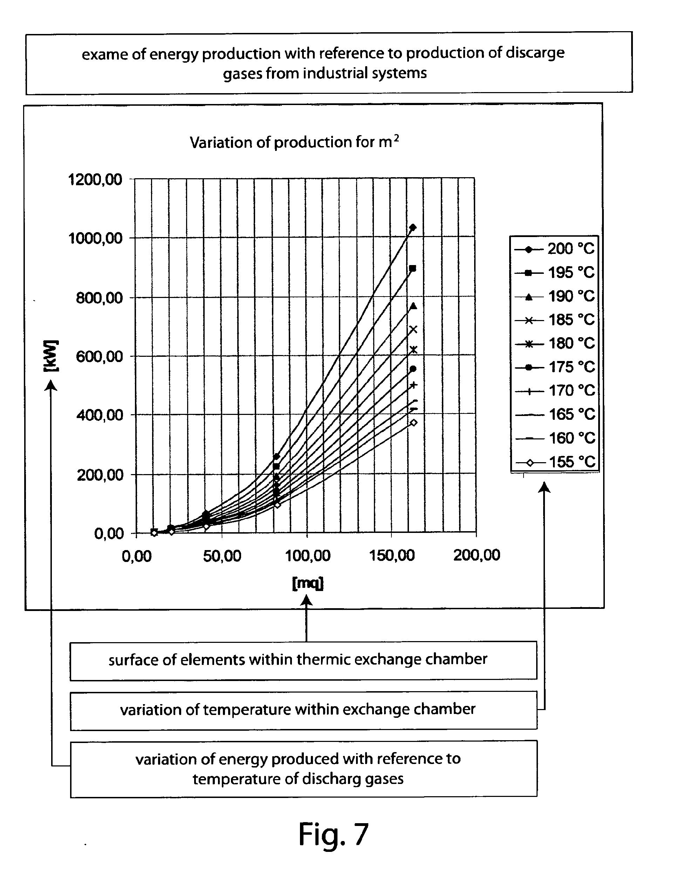

A graph is shown in figure 7, with the indication of efficiencies obtained applying the innovative system with a thermal exchange chamber to every system with discharge gases.

Electric energy produced by placing the electropositive conductor 10 and the electronegative conductor 20 in series will be multiplied four times doubling the surface exposed to the thermal exchange and doubling the exchange elements.

Example:
- a 5x10 cm panel with a total number of 27 elements exposed at a temperature of about 20° will produce about mV 4.8 x ma 0.48.
- a 10x10 cm panel with a total number of 54 elements exposed at a temperature of about 20° will produce about mV 9.6 x mA 0.96.
- two 10x10 cm panels with a total number of 108 elements exposed at a temperature of about 20° will produce about mV 19.2 x mA 1.92.

As it can be noted, doubling the exchange surface and the number of elements, electric efficiency is multiplied by four times; photos showing an experimental model at low temperatures are enclosed.

Among the application fields of the solution according to the invention, the following can be indicated:
- heat recovered from behind photovoltaic panels;
- realization of new solar panels without silicium for production of electric energy;
- recovery of discharge gases from co-generation systems;
- recovery of discharge gases from exothermic systems (boilers);
- recovery of discharge gases of endothermic systems;
- production of electric energy from geothermic systems;
- production of electric energy from gas burnt by oil well torch;
- production of electric energy between the different temperature of water and air applied to boats.

In traditional systems, a series connection permits doubling only the value of voltage, doubling its electric value, while the solution according to the invention doubles both voltage and amperage permitting multiplying four times its electric value.

On the contrary, increasing temperature, solution according to the invention permits having an electric production increasing exponentially, being it possible employing it in many applicative fields; photos showing an experimental model are herewith enclosed.

According to the invention, it has been noted that positioning two panels in parallel, it is obtained an increase of electric energy corresponding to the double of power of a single panel. Thus, according to the invention, electrons permits exponentially accelerating on the basis of the length of the series of metallic conductors; interrupting the series, it is interrupted speed of electron and thus production of electric energy will be halved.

The present invention has been described for illustrative but not limitative purposes, according to its preferred embodiments, but it is to be understood that modifications and/or changes can be introduced by those skilled in the art without departing from the relevant scope as defined in the enclosed claims.

## Claims

1. Thermoelectric generator suitable to transform thermal energy into electric energy exploiting low, medium and high temperatures, **characterized in** there are provided, in series, an electropositive conductor and an electronegative conductor, placed between two substantially parallel elements or panels, having coupling points of said conductors respectively on a hot side and on a cold side, said arrangement being provided within a structure wherein a thermal exchange is generated yielding heat, and with generation of electric energy.

2. Thermoelectric generator according to claim 1, **characterized in that** said conductors are connected in series each other, so as to create a single and continuous body, said conductors being realized employing at least two different metallic wires welded at their ends and insulated each other, so as to realizes a continuous series of welded joints on the hot side of the panel and a continuous series on the cold side of the panel.

3. Thermoelectric generator according to claim 1 or 2, **characterized in that** two metallic conductors are provided, respectively an electropositive and an electronegative conductors, welded each other at their ends so as to realize a thermocouple based on the Seebeck effect, all the metallic pairs being weld in series each other.

4. Thermoelectric generator according to claim 1, 2 or 3, **characterized in that** said thermoelectric generator is comprised of modules and electrodes connected in series each other so as to transform thermal energy into electric energy.

5. Thermoelectric generator according to one of the preceding claims, **characterized in that** said thermoelectric generator is used as solar panel for production of electric energy, or as additional panel to the photovoltaic panel to increase production of electric energy exploiting heat of the same photovoltaic panel, or to produce electric energy from discharge gases of exothermic systems, or to produce electric energy from discharge gases of endothermic systems, or to produce electric energy from return energy of geothermic systems, or for producing electric energy from flame heat of gases burnt within oil refineries and systems, or for producing electric energy between the different temperature of water and air applied to boats.
